# EUROPÄISCHE PATENTSCHRIFT

(11) **EP 2 124 335 B1**
(45) Veröffentlichungstag und Bekanntmachung des Hinweises auf die Patenterteilung: **28.03.2018**
(21) Anmeldenummer: 09159307.9
(22) Anmeldetag: 04.05.2009
(51) Int. Cl.: H03H 17/02

(54) **Verfahren zum Optimieren einer mehrstufigen Filterbank sowie entsprechende Filterbank und Hörvorrichtung**
Method for optimising a multi-stage filter bank and corresponding filter bank and hearing aid
Procédé d'optimisation d'un banc de filtres multi-étage ainsi que banc de filtres correspondant et dispositif auditif

(30) Priorität: 21.05.2008 DE 102008024535
(43) Veröffentlichungstag der Anmeldung: 25.11.2009
(73) Patentinhaber: Sivantos Pte. Ltd., Singapore 539775 (SG)
(72) Erfinder: Alfsmann, Daniel, 44787 Bochum (DE)
(74) Vertreter: FDST Patentanwälte

(56) Entgegenhaltungen:
- LUNNER T ET AL: "A digital filterbank hearing aid-design, implementation and evaluation", SPEECH PROCESSING 1. TORONTO, MAY 14 - 17, 1991; [INTERNATIONAL CONFERENCE ON ACOUSTICS, SPEECH & SIGNAL PROCESSING. ICASSP], NEW YORK, IEEE, US, Bd. CONF. 16, 14. April 1991 (1991-04-14), Seiten 3661-3664, XP010043963, DOI: 10.1109/ICASSP.1991.151068 ISBN: 978-0-7803-0003-3
- HERMANN D ET AL: "Window Based Prototype Filter Design for Highly Oversampled Filter Banks in Audio Applications", 2007 IEEE INTERNATIONAL CONFERENCE ON ACOUSTICS, SPEECH, AND SIGNAL PROCESSING 15-20 APRIL 2007 HONOLULU, HI, USA, IEEE, PISCATAWAY, NJ, USA, 15. April 2007 (2007-04-15), Seiten II-405-II-408, XP031463202, ISBN: 978-1-4244-0727-9
- ENEMAN K ET AL: "DFT modulated filter bank design for oversampled subband systems", SIGNAL PROCESSING, ELSEVIER SCIENCE PUBLISHERS B.V. AMSTERDAM, NL, Bd. 81, Nr. 9, 1. September 2001 (2001-09-01), Seiten 1947-1973, XP004297739, ISSN: 0165-1684, DOI: 10.1016/S0165-1684(01)00084-6
- BRENNAN R ET AL: "A flexible filterbank structure for extensive signal manipulations in digital hearing aids", CIRCUITS AND SYSTEMS, 1998. ISCAS '98. PROCEEDINGS OF THE 1998 IEEE IN TERNATIONAL SYMPOSIUM ON MONTEREY, CA, USA 31 MAY-3 JUNE 1998, NEW YORK, NY, USA,IEEE, US, Bd. 6, 31. Mai 1998 (1998-05-31), Seiten 569-572, XP010289846, DOI: 10.1109/ISCAS.1998.705338 ISBN: 978-0-7803-4455-6
- YU SHAO ET AL: "A Generalized Time-Frequency Subtraction Method for Robust Speech Enhancement Based on Wavelet Filter Banks Modeling of Human Auditory System", IEEE TRANSACTIONS ON SYSTEMS, MAN AND CYBERNETICS. PART B:CYBERNETICS, IEEE SERVICE CENTER, PISCATAWAY, NJ, US, Bd. 37, Nr. 4, 1. August 2007 (2007-08-01) , Seiten 877-889, XP011187018, ISSN: 1083-4419, DOI: 10.1109/TSMCB.2006.885306

## Beschreibung

Die vorliegende Erfindung betrifft ein Verfahren zum Optimieren einer Struktur einer mehrstufigen Filterbank, die eine eingangsseitige und eine ausgangsseitige Filterbank auf der Basis eines vorgegebenen Filtertyps aufweist, wobei die eingangsseitige Filterbank als variierbaren ersten Parameter die Eingangskanalzahl und als variierbaren zweiten Parameter einen Überabtastfaktor besitzt. Darüber hinaus betrifft die vorliegende Erfindung eine mehrstufige Filterbank, deren Struktur mit Hilfe eines obigen Verfahrens gewonnen ist. Ferner betrifft die vorliegende Erfindung auch eine Hörvorrichtung mit einer derartigen mehrstufigen Filterbank. Unter dem Begriff "Hörvorrichtung" wird hier jedes im oder am Ohr tragbare, schallausgebende Gerät, insbesondere ein Hörgerät, ein Headset, Kopfhörer und dergleichen, verstanden.

Hörgeräte sind tragbare Hörvorrichtungen, die zur Versorgung von Schwerhörenden dienen. Um den zahlreichen individuellen Bedürfnissen entgegenzukommen, werden unterschiedliche Bauformen von Hörgeräten wie Hinter-dem-Ohr-Hörgeräte (HdO), Hörgerät mit externem Hörer (RIC: receiver in the canal) und In-dem-Ohr-Hörgeräte (IdO), z.B. auch Concha-Hörgeräte oder Kanal-Hörgeräte (ITE, CIC), bereitgestellt. Die beispielhaft aufgeführten Hörgeräte werden am Außenohr oder im Gehörgang getragen. Darüber hinaus stehen auf dem Markt aber auch Knochenleitungshörhilfen, implantierbare oder vibrotaktile Hörhilfen zur Verfügung. Dabei erfolgt die Stimulation des geschädigten Gehörs entweder mechanisch oder elektrisch.

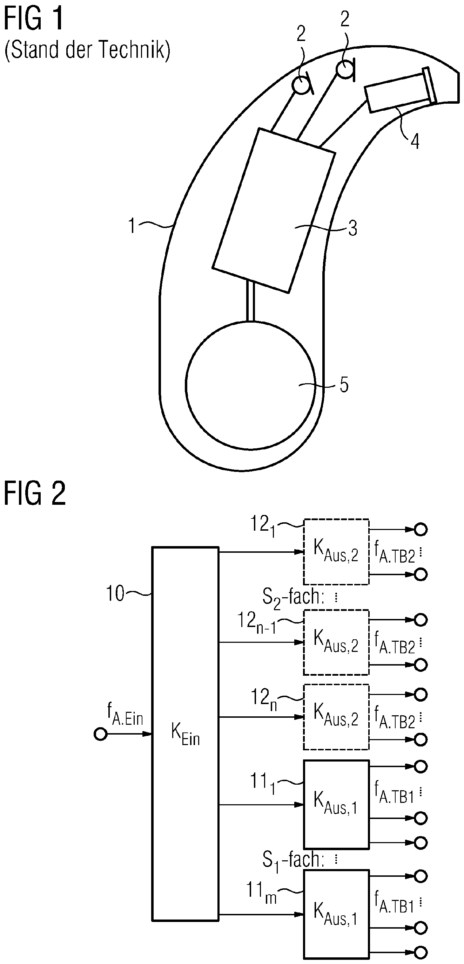

Hörgeräte besitzen prinzipiell als wesentliche Komponenten einen Eingangswandler, einen Verstärker und einen Ausgangswandler. Der Eingangswandler ist in der Regel ein Schallempfänger, z. B. ein Mikrofon, und/oder ein elektromagnetischer Empfänger, z. B. eine Induktionsspule. Der Ausgangswandler ist meist als elektroakustischer Wandler, z. B. Miniaturlautsprecher, oder als elektromechanischer Wandler, z. B. Knochenleitungshörer, realisiert. Der Verstärker ist üblicherweise in eine Signalverarbeitungseinheit integriert. Dieser prinzipielle Aufbau ist in FIG 1 am Beispiel eines Hinter-dem-Ohr-Hörgeräts dargestellt. In ein Hörgerätegehäuse 1 zum Tragen hinter dem Ohr sind ein oder mehrere Mikrofone 2 zur Aufnahme des Schalls aus der Umgebung eingebaut. Eine Signalverarbeitungseinheit 3, die ebenfalls in das Hörgerätegehäuse 1 integriert ist, verarbeitet die Mikrofonsignale und verstärkt sie. Das Ausgangssignal der Signalverarbeitungseinheit 3 wird an einen Lautsprecher bzw. Hörer 4 übertragen, der ein akustisches Signal ausgibt. Der Schall wird gegebenenfalls über einen Schallschlauch, der mit einer Otoplastik im Gehörgang fixiert ist, zum Trommelfell des Geräteträgers übertragen. Die Energieversorgung des Hörgeräts und insbesondere die der Signalverarbeitungseinheit 3 erfolgt durch eine ebenfalls ins Hörgerätegehäuse 1 integrierte Batterie 5.

Schallsignale, die von einem oder mehreren Mikrophonen eines Hörgeräts aufgenommen werden, werden üblicherweise zur weiteren Verarbeitung in Teilbandsignale zerlegt. Hierzu bedient man sich meist einer oder mehrerer frequenzselektiver digitaler Analyse-Filterbänke (AFB), wodurch K>1 Teilbandsignale erhalten werden. Nach der Zerlegung können teilbandspezifische Signalmanipulationen durchgeführt werden. Eine anschließende Resynthese der manipulierten Teilbandsignale kann mittels einer digitalen Synthese-Filterbank (SFB) erfolgen.

An hochwertige Filterbänke in Hörgeräten werden gewisse Anforderungen gestellt. So wird beispielsweise in den untersten Bändern eine Kanalbandbreite von etwa 250 Hz benötigt. Ansonsten sollte sich der Bandabstand in etwa nach der Bark-Skala richten. Ferner ist eine Kanalzahl von mindestens 22 wünschenswert. Störanteile durch Aliasing sollen sicher unterhalb von 60dB liegen. Aufgrund der intensiven Teilbandverarbeitung (insbesondere die hohe erforderliche Verstärkung zur Kompensation des Hörschadens) bei Hörgeräten sind herkömmliche Verfahren zur Auslöschung von Aliasing nicht wirksam. Die Filterbänke sind daher grundsätzlich "nicht kritisch" abzutasten. Des Weiteren sollte die Gruppenlaufzeit (jeweils für AFB und SFB) deutlich unter 5 ms liegen und die Gruppenlaufzeitverzerrungen einen gewissen Rahmen nicht überschreiten. Insbesondere für hohe Frequenzen ist dabei die Gruppenlaufzeit so gering wie möglich zu halten, was einen wesentlichen limitierenden Faktor für die Filterbank darstellt.

Bislang werden bereits Filterbänke mit mehrstufiger Baumstruktur und ungleichförmiger Aufteilung (Bark-Skala), jedoch ohne optimierter Sperrbereichsdämpfung und damit fehlender oder unzureichender Abwärtstastung eingesetzt (Lösung A). Darüber hinaus ist auch bekannt, eine einstufige (bspw. komplex modulierte) Filterbank einzusetzen (Lösung B). Schließlich werden für die Zerlegung der Schallsignale auch mehrstufige Filterbänke eingesetzt (Lösung C). Eine derartige Filterbank ist beispielsweise mit K Kanälen mit mindestens zwei unterschiedlichen Bandbreiten ausgestattet, wobei sich die Bandbreiten an den Randbedingungen der Bark-Skala orientieren, Kanalgruppen jedoch identische Bandbreite besitzen. Dadurch ergeben sich Vorteile gegenüber den Lösungen A und B.

Weiterhin ist durch die mehrstufige Filterbank eine erhöhte Anzahl von Teilbändern möglich, um eine verbesserte Auflösung gegenüber der Lösung A erreichen zu können. Gleichzeitig besteht jedoch kein Zwang zur Realisierung einer überhöhten Anzahl von Teilbändern, was als Verbesserung gegenüber der Lösung B anzusehen ist.

Des Weiteren ist mit der mehrstufigen Filterbank eine Herabsetzung der Abtastrate der Teilbandsignale soweit möglich, wie es die Vermeidung von Störungen zulässt (Verbesserung gegenüber Lösung A). Die Herabsetzung der Abtastrate kann jedoch nur in dem Maße erfolgen, dass durch die Manipulation der Teilbandsignale keine Störungen durch spektrale Überfaltungen (Aliasing) entstehen. Dies führt zu einer Verbesserung gegenüber bekannten Filterbank-Verfahren zur Aliasing-Kompensation, wie sie beispielsweise beschrieben sind in Heinz Göckler und Alexandra Groth: "Multiratensysteme" Schlembach Verlag, Willburgstetten, 2004.

Aus dem Artikel von Brennan, R.; Schneider, T.: A flexible filterbank structure for extensive signal manipulations in digital hearing aids; In. IEEE, Proceedings of the International Symposium on Circuits and Systems 31 May-3 June 1998, 1998. ISCAS '98. Volume 6, S. 569 - 572 ist eine flexible Filterbankstruktur für Hörgeräte bekannt. Diese Filterbankstruktur setzt sich aus einer Analysefilterbank und einer Synthesefilterbank zusammen, zwischen denen eine kanalabhängige Verarbeitung durchgeführt wird. Es handelt sich um eine überabgetastete Filterbank, und es ist Ziel, eine möglichst kurze Zeitverzögerung und eine hohe Computereffizienz zu erreichen.

Darüber hinaus beschreibt der Artikel Yu Shao; Chip-Hong Chang: A Generalized Time-Frequency Subtraction Method for Robust Speech Enhancement Based on Wavelet Filter Banks Modeling of Human Auditory System. In: IEEE TRANSACTIONS ON SYSTEMS, MAN AND CYBERNETICS. PART B:CYBERNETICS, Vol. 37, No. 4, August 2007, 2007, S. 877 - 889 eine Filterbankmodellierung für ein menschliches Gehör. Zur Verbesserung der Sprachverständlichkeit wird das Signal-Rausch-Verhältnis verbessert.

Ferner ist der Artikel Lunner T et al.: "A digital filterbank hearing aid-design, implementation and evaluation", Speech Processing 1. Toronto, May 14 - 17, 1991; [International Conference on acoustics, speech & signal processing. ICASSP], New York, IEEE, US, Bd. CONF. 16, 14. April 1991 (1991-04-14), Seiten 3661-3664, ISBN:978-0-7803-0003-3 bekannt. Dort ist eine mehrstufige Filterbank beschrieben, die eine eingangsseitige und eine ausgangsseitige Filterbank auf der Basis eines vorgegebenen Filtertyps aufweist. Die eingangssei tige Filterbank besitzt als ersten Parameter die Kanalzahl 2 und als zweiten Parameter einen Überabtastfaktor 2.

Die Aufgabe der vorliegenden Erfindung besteht darin, eine mehrstufige Filterbank bereitstellen zu können, die eine möglichst geringe Gruppenlaufzeit in den Teilbändern aufweist und mit möglichst wenig Energieaufwand betrieben werden kann.

Erfindungsgemäß wird diese Aufgabe gelöst durch ein Verfahren zum Optimieren einer Struktur einer mehrstufigen Filterbank, die eine eingangsseitige und eine ausgangsseitige Filterbank mit Filtern eines vorgegebenen Filtertyps aufweist, wobei die eingangsseitige Filterbank als variierbaren ersten Parameter die Kanalzahl und als variierbaren zweiten Parameter einen Überabtastfaktor besitzt, umfassend die folgenden Schritte: Ermitteln jeweils einer Gruppenlaufzeit der mehrstufigen Filterbank für mehrere Wertepaare des ersten und zweiten Parameters, Ermitteln jeweils einer Operationsrate der mehrstufigen Filterbank für die mehrere Wertepaare des ersten und zweiten Parameters, Auswählen eines der mehreren Wertepaare, bei dem die zugehörige Gruppenlaufzeit und die zugehörige Operationsrate ein vorgegebenes Kriterium erfüllen, und Konfigurieren der eingangsseitigen Filterbank mit der Kanalzahl und dem Überabtastfaktor entsprechend dem ausgewählten Wertepaar.

In vorteilhafter Weise ist es so möglich, ein Filterbanksystem, das zahlreiche Parameter besitzt, wie Nutzkanalzahl der eingangsseitigen Filterbank, Überabtastfaktor der eingangsseitigen Filterbank, Anzahl der ausgangsseitigen Filterbänke, Nutzkanalzahl der ausgangsseitigen Filterbänke, Überabtastfaktor der ausgangsseitigen Filterbänke, Baumstruktur "voller Baum" oder "reduzierter Baum" usw., nur anhand weniger, gezielt ausgewählter Parameter erfolgreich zu optimieren. Es ist also nicht ein aufwendiges Optimierungsverfahren in einem mehrdimensionalen Raum notwendig.

Falls die mehrstufige Filterbank, d.h. das kaskadierte Filterbank-System, über die gesamte Bankbreite verschiedenstufig ist, kann für die mehreren Wertepaare jeweils zusätzlich eine Datenrate, die eine Abtastrate kumuliert über alle Teilbänder der mehrstufigen Filterbank darstellt, ermittelt und diese Datenrate für das Auswählen eines der mehreren Wertepaare herangezogen werden. Damit ergibt sich ein zusätzliches Auswertekriterium, mit dem der Ergebnisraum zielsicher eingeschränkt werden kann.

In einer Weiterentwicklung kann anstatt von üblicherweise verwendeten "perfekt rekonstruierenden" Filterbänken (PR-Filterbank) eine "näherungsweise perfekt rekonstruierende" Filterbank (NPR-Filterbank) verwendet werden. Eine NPR-Filterbank ist für eine intensive Teilbandverarbeitung meist hinreichend. Mit einer NPR-Filterbank lassen sich weiter Aufwand und Gruppenlaufzeit einsparen.

Ferner kann es sich bei jeder Teil-Filterbank des FilterbankSystems um eine überabgetastete, komplex modulierte reguläre (DFT) oder frequenzverschobene (GDFT) Polyphasen-Filterbank handeln. Derartige Filterbänke besitzen weitreichende Variationsmöglichkeiten, sind aber mit dem erfindungsgemäßen Verfahren leicht zu optimieren.

Das vorgegebene Kriterium für die Optimierung kann darin bestehen, dass die Gruppenlaufzeit und die Operationsrate möglichst gering sind. Besitzen beide Parameter nicht bei ein und demselben Wertepaar ein Minimum, so ist ein geeigneter Kompromiss für die Parameterwerte und das dazugehörige Wertepaar (Eingangskanalzahl und Überabtastfaktor) zu wählen.

Vorteilhafterweise kann nun mit dem erfindungsgemäßen Verfahren eine mehrstufige Filterbank gefunden werden, deren Struktur hinsichtlich Gruppenlaufzeit und Energieverbrauch optimiert ist. Insbesondere eignet sich eine derartige mehrstufige Filterbank zur Eingangssignalverarbeitung in Hörvorrichtungen, speziell in Hörgeräten.

Die vorliegende Erfindung wird nun anhand der beigefügten Zeichnungen näher erläutert, in denen zeigen:
- FIG 1: den prinzipiellen Aufbau eines Hörgeräts gemäß dem Stand der Technik;
- FIG 2: eine Baumstruktur eines zu optimierenden Basisfilterbankkonzepts;
- FIG 3: ein Diagramm der Gruppenlaufzeit der Frequenzgruppe der niedrigen Frequenzen in Abhängigkeit von K_{Ein} und U_{Ein};
- FIG 4: ein Diagramm der Operationsrate für Multiplikationen der gesamten Filterbank in Abhängigkeit von K_{Ein} und U_{Ein};
- FIG 5: ein Diagramm der Datenrate aller Teilbänder (gesamte Samplezahl pro Zeiteinheit) in Abhängigkeit von K_{Ein} und U_{Ein}; und
- FIG 6: eine Baumstruktur eines optimierten Filterbankkonzepts.

Die nachfolgend näher geschilderten Ausführungsformen stellen bevorzugte Ausführungsbeispiele der vorliegenden Erfindung dar. Für das erfindungsgemäße Optimierungsverfahren wird in dem folgenden Beispiel von einer Baumstruktur eines Filterbankkonzepts ausgegangen, wie es in FIG 2 dargestellt ist. Ein derartiges Basisfilterbankkonzept umfasst eine eingangsseitige Filterbank 10 und mehrere ausgangsseitige Filterbänke 11₁ bis 11ₘ und 12₁ bis 12ₙ. Die eingangsseitige Filterbank 10 besitzt eine Kanalzahl K_{Ein} = n+m. Die Abtastrate am Eingang der Filterbank 10 beträgt f_{A, Ein}.

Das Basisfilterbankkonzept ist in diesem Beispiel lediglich zweistufig ausgelegt. Es verfügt also neben der eingangsseitigen Filterbank 10 in der ersten Stufe lediglich über eine zweite Stufe mit den Filterbänken 11₁ bis 11ₘ und 12₁ bis 12ₙ, welche jeweils herkömmliche komplex modulierte Filterbänke darstellen. Die Filterbänke 11₁ bis 11ₘ besitzen eine Nutzkanalzahl K_{Aus,1}, während die Filterbänke 12₁ bis 12ₙ die Kanalzahl K_{Aus,2} besitzen. Die tatsächliche Kanalzahl entspricht dem Produkt U_{Ein} · K_{Aus,1,2}, wobei U_{Ein} den Überabtastfaktor der eingangsseitigen Filterbank repräsentiert.

Die ausgangsseitigen Filterbänke setzen sich in dem gewählten Beispiel also lediglich aus zwei verschiedenen Filterbanktypen zusammen. Dabei ist bei einem "vollen Baum" der Filterbanktyp mit der Kanalzahl K_{Aus,1} S₁-fach und derjenige mit der Kanalzahl K_{Aus,2} S₂-fach vertreten. Die Abtastrate am Ausgang der eingangsseitigen Filterbank 10 beträgt f_{A, Zw} und die Abtastraten an den Ausgängen der ausgangsseitigen Filterbänke 11₁ bis 11ₘ und 12₁ bis 12ₙ betragen f_{A, TB1} bzw. f_{A, TB2}.

Liegt lediglich ein "reduzierter Baum" vor, so werden die ausgangsseitigen Kanäle teilweise durch die eingangsseitige Filterbank 10 gebildet. Demnach kann beispielsweise auf die ausgangsseitigen Filterbänke 12₁ bis 12ₙ (in Fig. 2 gestrichelt gezeichnet) verzichtet werden.

Ziel ist es nun, die Struktur des Filterbanksystems von FIG 2 insbesondere hinsichtlich einer Anwendung in Hörgeräten zu optimieren. Dabei soll eine möglichst geringe Gruppenlaufzeit in den einzelnen Kanälen und insgesamt ein möglichst geringer Energieverbrauch, d.h. möglichst wenig Filteroperationen, erreicht werden. Es hat sich gezeigt, dass zur Optimierung der gesamte Parameterraum des Filterbanksystems auf im Wesentlichen zwei Parameter reduziert werden kann, nämlich die Eingangskanalzahl K_{Ein} und den Überabtastfaktor U_{Ein} der eingangsseitigen Filterbank 10.

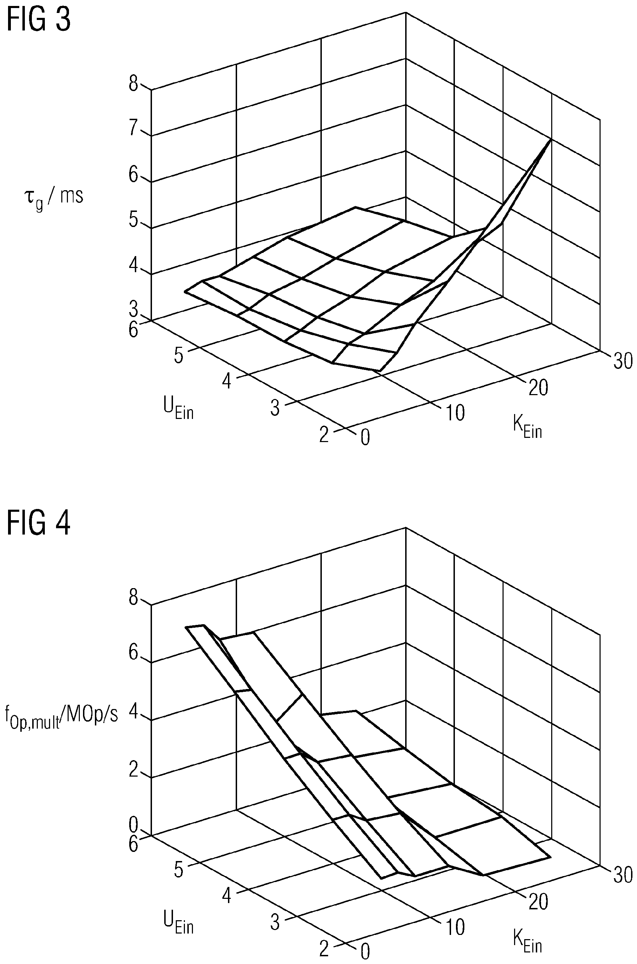

Zunächst wird die Gruppenlaufzeit einer Frequenzgruppe der niedrigen Frequenzen in Abhängigkeit der beiden Parameter K_{Ein} und U_{Ein} untersucht. Für die Untersuchung, wie auch für alle folgenden Untersuchungen werden Filter gemäß dem Remez-Standardentwurf (linearphasige FIR-Filter) verwendet. Die dreidimensionale Graphik von FIG 3 gibt die Gruppenlaufzeit τ_{g} über den Parametern U_{Ein} und K_{Ein} wieder. Es zeigt sich ein deutlicher Anstieg der Gruppenlaufzeit für die Frequenzgruppe der niedrigen Frequenzen im rechten Eck, d.h. bei hohen Eingangskanalzahlen K_{Ein} und niedrigen Überabtastfaktoren U_{Ein}. Geringe Gruppenlaufzeiten liegen also eher im vorderen und hinteren Bereich der Graphik, sehr geringe Laufzeiten in der linken Ecke der Graphik, d.h. bei hohen Überabtastfaktoren U_{Ein} und niedrigen Eingangskanalzahlen K_{Ein}. Für höhere Frequenzen variiert die Gruppenlaufzeit in Abhängigkeit von U_{Ein} und K_{Ein} nur unwesentlich.

Hohe Überabtastfaktoren U_{Ein} führen jedoch zu einer hohen Anzahl an notwendigen Operationen, wodurch der Energieverbrauch steigt. Demzufolge ist ein Kompromiss zwischen Gruppenlaufzeit und Anzahl der Operationen bzw. Operationsrate zu finden. Daher wurde entsprechend FIG 4 die Operationsrate f_{OP,mult} (nur für Multiplikationen) der gesamten Filterbank in Abhängigkeit von K_{Ein} und U_{Ein} ermittelt. Die Multiplikations-Operationsrate kann hier stellvertretend für die gesamte Operationsrate der Filterbank angesehen werden. In der dreidimensionalen Graphik FIG 4 zeigt sich, dass die Operationsrate f_{OP,mult} im linken Eck, d.h. bei einem hohen Überabtastfaktor U_{Ein} und einer geringen Kanalzahl K_{Ein}, verhältnismäßig groß ist. Im vorderen und hinteren Eck der Graphik sind die Operationsraten deutlich geringer und im rechten Eck am geringsten, d.h. bei hoher Kanalzahl K_{Ein} und niedrigem Überabtastfaktor U_{Ein}. Im Rahmen der Optimierung müssen jedoch beide Optimierungskriterien, nämlich die Gruppenlaufzeit und die Operationsrate gleichzeitig betrachtet werden. Dabei stellt sich - wie oben bereits erwähnt - heraus, dass die Gruppenlaufzeit der Frequenzgruppe der hohen Frequenzen kaum kritisch ist und somit für die Optimierung nicht herangezogen zu werden braucht. Werden demnach die Figuren 3 und 4 zusammen betrachtet, so ergeben sich optimale Wertepaare der Parameter U_{Ein} und K_{Ein} im vorderen und hinteren Bereich der Ebene, die diese beiden Parameter U_{Ein} und K_{Ein} gemäß den Figuren 3 und 4 aufspannen.

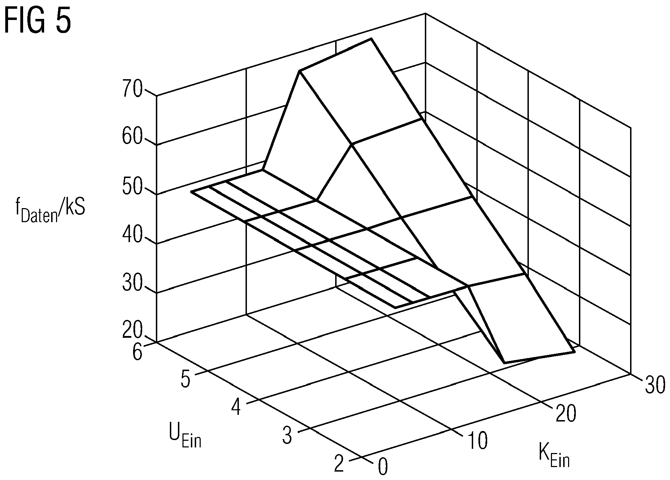

Als zusätzliches Entscheidungskriterium für das Finden eines optimalen Wertepaares U_{Ein}/K_{Ein} kann zusätzlich die sogenannte Datenrate "f_{Daten}" herangezogen werden. Sie ergibt sich aus allen Abtastraten kumuliert über alle Teilbänder. Wie FIG 5 zeigt, ist sie jedoch für einen "vollen Baum" des Filtersystems (vgl. FIG 2) konstant. Lediglich für einen "reduzierten Baum" ergibt sich eine Abhängigkeit von den Parametern U_{Ein} und K_{Ein}. In dem gewählten Beispiel wurde auf die ausgangsseitigen Filterbänke 12₁ bis 12ₙ verzichtet. Dadurch ergab sich eine Abhängigkeit der Datenrate f_{Daten} von den beiden Parametern K_{Ein} und U_{Ein}. Der dreidimensionalen Graphik von FIG 5 entsprechend wäre es am günstigsten, einen reduzierten Baum zu verwenden (hohe Kanalzahl K_{Ein}) und den Überabtastfaktor U_{Ein} der eingangsseitigen Filterbank möglichst gering zu halten. In diesem Wertepaarbereich ist jedoch die Gruppenlaufzeit verhältnismäßig hoch (gleiche FIG 3).

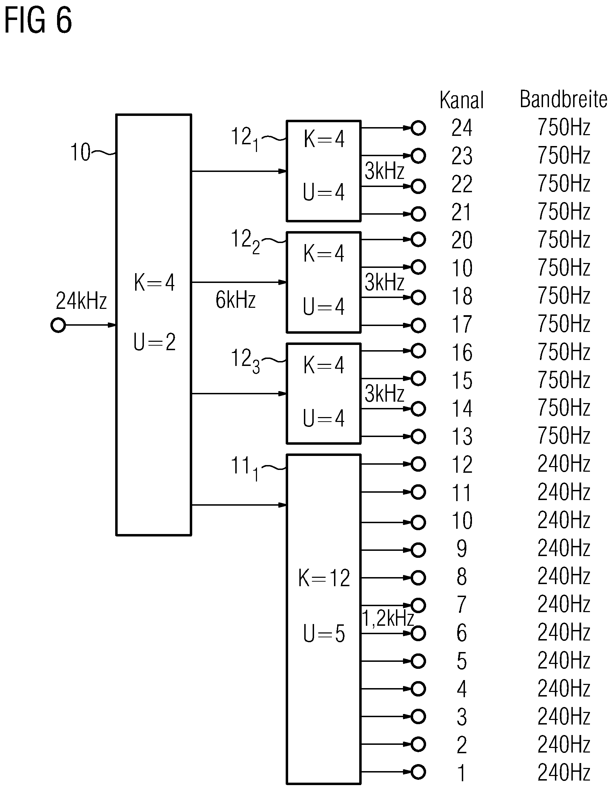

Insgesamt ist ein Kompromiss zu finden, der sämtlichen Optimierungskriterien (geringe Gruppenlaufzeit, geringe Operationsrate und ggf. geringe Datenrate) Rechnung trägt. In dem vorliegenden Beispiel stellte sich heraus, dass eine Filterbank mit der Baumstruktur gemäß FIG 6 als optimal angesehen werden kann. Demnach besitzt die eingangsseitige Filterbank 10 eine Kanalzahl K_{Ein} = 4 und einen Überabtastfaktor U_{Ein} = 2. Die optimale Struktur führt zu einem vollen Baum mit vier ausgangsseitigen Filterbänken 11₁, 12₁, 12₂ und 12₃. Die ausgangsseitige Filterbank 11₁ für den unteren Frequenzbereich besitzt die Kanalzahl K_{Aus} = 12 und den Überabtastfaktor U_{Aus} = 5. Für die oberen Frequenzen ergeben sich drei ausgangsseitige Filterbänke 12₁, 12₂ und 12₃ des gleichen Filterbanktyps. Sie besitzen jeweils die Kanalzahl K_{Aus} = 4 und einen Überabtastfaktor U_{Aus} = 4. Damit ergeben sich über den gesamten Frequenzbereich 24 Kanäle, also eine Kanalzahl, die entsprechend den ursprünglich aufgestellten Forderungen mindestens 22 beträgt. Auch die weitere Anforderung, dass in den untersten Bändern eine Kanalbandbreite von etwa 250 Hz benötigt wird, kann mit der Struktur von FIG 6 eingehalten werden. Bei dieser optimierten Filterbankstruktur besitzen nämlich die unteren Kanäle eine Bandbreite von 240 Hz und die oberen Kanäle eine Bandbreite von 750 Hz. Mit dem erfindungsgemäßen Optimierungsverfahren ist es somit möglich, eine mehrstufige Struktur aus überabgetasteten, komplex modulierten (modifizierten: GDFT) Polyphasen-Filterbänken speziell hinsichtlich der Anwendungen bei Hörvorrichtungen, insbesondere bei Hörgeräten, zu optimieren.

Für den Fall einer Einsetzung von frequenzverschobenen komplex modulierten (GDFT) Polyphasen-Filterbänken kann erfindungsgemäß für jede Teil-Filterbank jeweils die günstigste Lösung zur Realisierung der Frequenzverschiebung ausgewählt werden: In ersten Fall wird das Eingangssignal der jeweiligen Teilfilterbank selbst frequenzversetzt, wobei das Prototypfilter weiterhin reelle Koeffizienten aufweist, aber mit einem komplexen Signal gespeist wird (Realisierung als DFT-Filterbank). Das Ausgangssignal muss dabei wieder in die Gegenrichtung frequenzverschoben werden. Im zweiten Fall wird das Prototypfilter selbst komplex moduliert, wodurch dieses komplexe Koeffizienten aufweist, aber mit einem reellen Signal gespeist wird. Um die evtl. vorliegende Symmetrie von FIR Filterkoeffizienten zu bewahren, wird die Nullphase der den Frequenzversatz bewirkenden Trägerschwingung geeignet gewählt.
Die Auswahl aus beiden Möglichkeiten geschieht wie folgt: Ist das Eingangssignal der jeweiligen Teilfilterbank reell, so wird die zweite Möglichkeit ausgewählt, ist es komplex, so die erste. In jedem Fall ergeben sich so auch für GDFT-Teilfilterbänke in den zu realisierenden Prototypfiltern nur halbkomplexe Multiplikationen. Bei einer mehrstufigen Filterbank können gegebenenfalls die im ersten Fall nötigen Frequenzverschiebungen vor und hinter der DFT-Filterbank zusammengefasst werden.

Eine weitere Verbesserung in Hinblick auf Rechenaufwand (Energieverbrauch) und Gruppenlaufzeit kann dadurch erreicht werden, dass anstelle herkömmlicher PR-Filterbänke ("perfekt rekonstruierender Filterbänke") NPR-Filterbänke ("nicht perfekt rekonstruierende Filterbänke") eingesetzt werden. Die NPR-Filterbänke können nämlich so gestaltet sein, dass sie für eine intensive Teilbandverarbeitung hinreichend sind.

Als eine aus mindestens zwei kaskadierten Stufen zusammengesetzte Filterbank bzw. als partiell mindestens zweistufige (Analyse-)Filterbank kann sie zur Zerlegung des Eingangssignals in K Teilbandsignale mit verminderter Abtastrate dienen. Eine digitale Synthesefilterbank (SFB) zur Resynthese nach der Manipulation der Teilbandsignale kann symmetrisch zu der Analyse-Filterbank (AFB) aufgebaut sein.

Insgesamt lässt sich mit der optimierten Filterbankstruktur eine kleinere Gruppenlaufzeit insbesondere bei den breitbandigeren, bei höheren Mittenfrequenzen zentrierten Kanälen erreichen, was eine Verbesserung gegenüber der einleitend geschilderten Lösung B darstellt. Als weiterer Vorteil des optimierten Filterbanksystems lässt sich der verminderte Rechenaufwand in der Analyse-Synthese-Filterbankkaskade nennen, was insbesondere eine Verbesserung gegenüber einer nicht optimierten Lösung C darstellt. Schließlich ergibt sich in vorteilhafter Weise auch ein stark verminderter Rechenaufwand in der Teilbandsignalverarbeitung durch Abwärtstastung der Teilbandsignale und Vermeidung einer überhöhten Kanalanzahl.

Das oben beschriebene Filterbanksystem lässt sich beispielsweise in einem Hörgerät oder einer anderen Hörvorrichtung einsetzen.

## Patentansprüche

1. Verfahren zum Optimieren einer Struktur einer mehrstufigen Filterbank, die eine eingangsseitige (10) und eine ausgangsseitige Filterbank (11₁, 11ₘ, ; 12₁, 12ₙ) mit Filtern eines vorgegebenen Filtertyps aufweist, wobei die eingangsseitige Filterbank (10) als variierbaren ersten Parameter die Kanalzahl (K_{Ein}) und als variierbaren zweiten Parameter einen Überabtastfaktor (U_{Ein}) besitzt,
**gekennzeichnet durch**
- Ermitteln jeweils einer Gruppenlaufzeit (τ_{g}) der mehrstufigen Filterbank für mehrere Wertepaare des ersten und zweiten Parameters,
- Ermitteln jeweils einer Operationsrate (f_{Op,mult}) der mehrstufigen Filterbank für die mehreren Wertepaare des ersten und zweiten Parameters,
- Auswählen eines der mehreren Wertepaare, bei dem die zugehörige Gruppenlaufzeit (τ_{g}) und die zugehörige Operationsrate (f_{Op,mult}) ein vorgegebenes Kriterium erfüllen, und
- Konfigurieren der eingangsseitigen Filterbank (10) mit der Kanalzahl und dem Überabtastfaktor entsprechend dem ausgewählten Wertepaar.

2. Verfahren nach Anspruch 1,
wobei die mehrstufige Filterbank über die gesamte Bandbreite verschiedenstufig ist, für die mehreren Wertepaare jeweils zusätzlich als Datenrate eine Abtastrate kumuliert über alle Teilbänder der mehrstufigen Filterbank ermittelt wird und die jeweilige Datenrate für das Auswählen eines der mehreren Wertepaare herangezogen wird.

3. Verfahren nach Anspruch 1 oder 2,
wobei es sich bei der eingangsseitigen und der ausgangsseitigen Filterbank in Bezug auf eine Synthese-Filterbank jeweils um eine NPR-Filterbank handelt.

4. Verfahren nach einem der vorhergehenden Ansprüche,
wobei es sich bei der eingangsseitigen und der ausgangsseitigen Filterbank jeweils um eine überabgetastete, komplex modulierte Polyphasen-Filterbank handelt .

5. Verfahren nach einem der vorhergehenden Ansprüche, wobei das vorgegebene Kriterium darin besteht, dass die Gruppenlaufzeit (τ_{g}) und die Operationsrate (f_{Op,mult}) möglichst gering sind.

## Claims

1. A method for optimizing a structure of a multilevel filter bank which comprises an input-side filter bank (10) and an output-side filter bank (11₁, 11ₘ,; 12₁, 12ₙ) with filters of a defined filter type, with the input-side filter bank (10) having the channel number (K_{Ein}) as a variable first parameter, and an oversampling factor (U_{Ein}) as a variable second parameter,
**characterized by**
- determining a group delay (τ_{g}) of the multilevel filter bank for each of a plurality of value pairs of the first and second parameters,
- determining an operation rate (f_{Op,mult}) of the multilevel filter bank for each of the plurality of value pairs of the first and second parameters,
- selecting one of the plurality of value pairs for which the associated group delay (τ_{g}) and the associated operation rate (f_{Op,mult}) satisfy a defined criterion, and
- configuring the input-side filter bank (10) with the channel number and the oversampling factor corresponding to the selected value pair.

2. The method as claimed in claim 1, wherein levels of the multilevel filter bank differ across the full band width, a cumulative sampling rate across all subbands of the multilevel filter bank is additionally determined as the data rate for each of the plurality of value pairs, and the respective data rate is used to select one of the plurality of value pairs.

3. The method as claimed in claim 1 or 2, wherein the input-side and output-side filter banks, with regard to a synthesis filter bank, are each an NPR filter bank.

4. The method as claimed in one of the preceding claims, wherein the input-side and output-side filter banks are each an oversampled, complex modulated polyphase filter bank.

5. The method as claimed in one of the preceding claims, wherein the defined criterion is to minimize the group delay (τ_{g}) and the operation rate (f_{Op,mult}).

## Revendications

1. Procédé d'optimisation d'une structure constituée d'un banc de filtres à plusieurs étages, comportant un banc de filtres côté entrée (10) et un banc de filtres côté sortie (11₁, 11ₘ ; 12₁, 12ₙ) comprenant des filtres ayant un type de filtre prédéfini, dans lequel le banc de filtres côté entrée (10) présente en tant que premier paramètre variable le nombre de canaux (K_{Ein}) et en tant que second paramètre variable, un facteur de suréchantillonnage (U_{Ein}), **caractérisé par** le fait de
- déterminer un temps de propagation de groupe (τ_{g}) respectif du banc de filtres à plusieurs étages pour plusieurs paires de valeurs des premier et second paramètres,
- déterminer un taux de fonctionnement (f_{Op,mult}) respectif du banc de filtres à plusieurs étages pour la pluralité de paires de valeurs des premier et second paramètres,
- sélectionner l'une de la pluralité de paires de valeurs pour laquelle le temps de propagation de groupe associé (τ_{g}) et le taux de fonctionnement associé (f_{Op,mult}) respectent un critère prédéfini, et
- configurer le banc de filtres côté entrée (10) avec le nombre de canaux et le facteur de suréchantillonnage conformément à la paire de valeurs sélectionnée.

2. Procédé selon la revendication 1,
dans lequel le banc de filtres à plusieurs étages est constitué d'étages différents sur la totalité de la largeur de bande, une fréquence d'échantillonnage est en outre respectivement déterminée de manière cumulative pour la pluralité de paires de valeurs en tant que débit de données sur la totalité des sous-bandes du banc de filtres à plusieurs étages et le débit de données respectif est utilisé pour sélectionner l'une de la pluralité de paires de valeurs.

3. Procédé selon la revendication 1 ou 2,
dans lequel les bancs de filtres côté entrée et côté sortie, par rapport à un banc de filtres de synthèse, sont respectivement un banc de filtres NPR.

4. Procédé selon l'une des revendications précédentes, dans lequel les bancs de filtres côté entrée et côté sortie sont respectivement un banc de filtres polyphasés modulés complexes et suréchantillonnés.

5. Procédé selon l'une des revendications précédentes, dans lequel le critère prédéfini consiste en ce que le temps de propagation du groupe (τ_{g}) et le taux de fonctionnement (f_{Op,mult}) sont aussi faibles que possible.
